(19) Europäisches Patentamt / European Patent Office / Office européen des brevets

(11) **EP 4 723 296 A1**

(12) **DEMANDE DE BREVET EUROPEEN**

(43) Date de publication:
**08.04.2026 Bulletin 2026/15**

(21) Numéro de dépôt: **25199865.4**

(22) Date de dépôt: **03.09.2025**

(51) Classification Internationale des Brevets (IPC):
**H01M 10/48** (2006.01)  **G01R 31/378** (2019.01)
**H01M 10/0525** (2010.01)  **G01R 31/367** (2019.01)

(52) Classification Coopérative des Brevets (CPC):
**H01M 10/48; G01R 31/367; G01R 31/378; H01M 10/0525**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **03.10.2024 FR 2410669**

(71) Demandeur: **Commissariat à l'Energie Atomique et aux Energies Alternatives**
**75015 Paris (FR)**

(72) Inventeurs:
• **KLEIN, Jean-Marie**
  **38054 GRENOBLE CEDEX 09 (FR)**
• **DESEURE, Jonathan**
  **38054 GRENOBLE CEDEX 09 (FR)**

(74) Mandataire: **Santarelli**
**Tour Trinity**
**1 bis Place de la Défense**
**92400 Courbevoie (FR)**

(54) **MÉTHODE ET DISPOSITIF POUR TRIER DES CELLULES DE BATTERIES LITHIUM-ION SELON LEUR TYPE**

(57) Méthode (100) pour identifier le type d'une cellule de batterie lithium-ion parmi au moins deux types de batterie associés chacun respectivement à une tension de pleine charge différente. La méthode comprend au moins une étape de discrimination (200) comprenant une ou plusieurs itérations (210). Chaque itération comprend :
- une collecte (211) d'une pluralité de mesures de courant de floating effectuées au niveau de la cellule pendant une charge à tension constante effectuée à une tension correspondant à la tension de pleine charge la plus basse parmi celles associées aux différents types de batterie,
- une décomposition (213) EMD de la dérivée du courant de floating,
- un calcul (215) d'une densité spectrale à partir des composantes intrinsèques de la décomposition EMD,
- une recherche (216) d'un minimum de la densité spectrale.

Le type de la cellule est classé (220) en fonction du résultat de la recherche de minimum.

[Fig. 1]

100, 200

- 210
- Collecte de mesures de courant de floating de la cellule — 211
- Obtention d'un signal de dérivée du courant de floating — 212
- Décomposition en modes empiriques (EMD) du signal de dérivée du courant de floating — 213
- Analyse de fiabilité — 214
- Calcul d'une densité spectrale de puissance à partir des composantes intrinsèques de la décomposition EMD — 215
- Recherche d'un minimum de la densité spectrale de puissance — 216
- Classification du type de la cellule en fonction des recherches de minimum des différentes itérations — 220

EP 4 723 296 A1

## Description

### Domaine de l'invention

La présente invention appartient au domaine de la gestion des batteries de type « lithium-ion ». Plus particulièrement, il est proposé une méthode et un dispositif pour identifier le type d'une cellule de batterie lithium-ion parmi plusieurs types de batterie associés chacun respectivement à une tension de pleine charge différente.

### Etat de la technique

Le tri des cellules de batterie lithium-ion en fonction de leur chimie spécifique est essentiel pour le recyclage et la gestion de la fin de vie des batteries. En effet, des cellules de batterie présentant des chimies différentes nécessiteront des procédés de traitement différents pour leur recyclage, ou des applications différentes pour leur réutilisation en seconde vie.

Parmi les différents types de chimie de batterie lithium-ion, on peut citer par exemple le type LFP (Lithium-Fer-Phosphate, $LiFePO_4$), le type NCA (Nickel-Cobalt-Aluminium, $LiNiCoAlO_2$), ou le type NMC (Nickel-Manganèse-Cobalt, $LiNi_xMn_yCo_zO_2$). Ces différents types de batterie sont notamment utilisés dans le secteur industriel ou dans le secteur automobile. D'autres types de batterie lithium-ion existent, notamment pour alimenter des appareils de taille plus petite, comme par exemple la chimie LCO (Lithium-Cobalt-Oxyde, $LiCoO_2$) ou la chimie LMO (Lithium-Manganèse-Oxyde, $LiMn_2O_4$).

Les différentes chimies qui composent la famille des batteries lithium-ion présentent généralement des tensions de pleine charge différentes. Par exemple, la tension de pleine charge d'une batterie de type LFP est de 3,65 V ; la tension de pleine charge d'une batterie de type NCA est de 4,2 V ; la tension de pleine charge d'une batterie de type NMC est de 4,3 V.

Ces différentes valeurs de tension de pleine charge sont fournies par les fabricants de batterie, et il convient de les respecter scrupuleusement pour éviter des problèmes de sécurité comme par exemple des emballement thermiques.

Pour déterminer l'état de santé d'une cellule de batterie en fin de première vie, afin de décider par exemple si la cellule doit être recyclée ou si elle peut être réutilisée en seconde vie, il est généralement nécessaire de réaliser plusieurs cycles de charge et de décharge de la cellule. Pour ce faire, il est nécessaire de connaître le type de la cellule afin de savoir quelle tension de charge appliquer.

Il est parfois possible d'identifier le type de chimie d'une cellule de batterie en fonction d'une identification visuelle (code-barre, étiquette ou caractéristique physique du boîtier de la batterie par exemple).

Lorsque le type d'une cellule ne peut pas être déterminé à l'aide d'une simple identification visuelle, il est envisageable de procéder à une analyse spectroscopique pour identifier les éléments chimiques présents à l'intérieur de la cellule. Il existe par exemple des méthodes de tri de batterie par spectrométrie par fluorescence X (XRF pour « X-Ray Fluorescence » en anglais) ou par spectroscopie d'impédance électrochimique (EIS pour « Electrochemical Impedance Spectroscopy » en anglais). Ces méthodes sont toutefois relativement complexes à mettre en œuvre.

### Exposé de l'invention

La présente invention a pour objectif de remédier à tout ou partie des inconvénients de l'art antérieur, notamment ceux exposés ci-avant, en proposant une solution innovante et facile à mettre en œuvre pour trier des cellules de batteries lithium-ion selon leur type de chimie.

A cet effet, et selon un premier aspect, il est proposé une méthode pour identifier le type d'une cellule de batterie lithium-ion parmi au moins deux types de batterie associés chacun respectivement à une tension de pleine charge différente. La méthode comprend au moins une étape de discrimination comprenant une ou plusieurs itérations. Chaque itération comprend :

- une collecte d'une pluralité de mesures de courant effectuées au niveau de la cellule pendant une phase tension constante, ou phase CV, d'une charge « courant constant - tension constante », ou charge CC-CV, de la cellule, la phase CV étant effectuée avec une tension de charge correspondant à la tension de pleine charge la plus basse parmi les tensions de pleine charge associées auxdits au moins deux types de batterie, la pluralité de mesures formant un signal de « courant de floating »,
- une dérivation du signal de courant de floating pour obtenir un signal de dérivée du courant de floating,
- une décomposition en modes empiriques du signal de dérivée du courant de floating afin d'en obtenir une représentation sous la forme d'une somme d'un signal résiduel et d'une ou plusieurs composantes intrinsèques,
- un calcul d'une densité spectrale à partir des composantes intrinsèques obtenues par la décomposition en modes empiriques,
- une recherche d'un minimum de la densité spectrale.

L'étape de discrimination comprend un classement du type de la cellule en fonction d'un critère déterminé à partir d'un résultat de la recherche de minimum pour ladite au moins une itération.

Dans des modes particuliers de mise en œuvre, la méthode peut comporter en outre l'une ou plusieurs des caractéristiques suivantes, prises isolément ou selon toutes les combinaisons techniquement possibles.

Dans des modes particuliers de mise en œuvre, ladite au moins une étape de discrimination comprend plusieurs itérations, et le critère est déterminé en fonction des résultats des recherches de minimum obtenus pour les différentes itérations.

Dans des modes particuliers de mise en œuvre, le critère est satisfait si un minimum $f_{min}$ de la densité spectrale *PSD* pour lequel il existe $f < f_{min}$ tel que

$$PSD(f_{min}) \leq \frac{PSD(f)}{2}$$ est trouvé pour un nombre ou un ratio prédéterminé d'itérations.

Dans des modes particuliers de mise en œuvre, la méthode est utilisée pour identifier le type de la cellule parmi au moins trois types de batterie associés chacun respectivement à une tension de pleine charge différente. La méthode comporte une première discrimination pour laquelle la phase CV est effectuée pour chaque itération avec une tension de charge correspondant à la tension de pleine charge la plus basse parmi les tensions de pleine charge associées auxdits au moins trois types de batterie. Si le critère est satisfait pour la première discrimination, le type de la cellule correspond au type associé à la tension de pleine charge la plus basse. Si le critère n'est pas satisfait pour la première discrimination, le type de la cellule correspond à un type différent du type associé à la tension de pleine charge la plus basse, et la méthode comporte une deuxième discrimination pour laquelle la phase CV est effectuée pour chaque itération avec une tension de charge correspondant à la deuxième tension de pleine charge la plus basse parmi les tensions de pleine charge associées auxdits au moins trois types de batterie. Si le critère est satisfait pour la deuxième discrimination, le type de la cellule correspond au type associé à la deuxième tension de pleine charge la plus basse. Si le critère n'est pas satisfait pour la deuxième discrimination, le type de la cellule correspond à un type différent du type associé à la deuxième tension de pleine charge la plus basse.

Dans des modes particuliers de mise en œuvre, la méthode comporte une étape préalable de comparaison d'une tension de la cellule avec la tension de pleine charge la plus basse parmi les tensions de pleine charge associées auxdits au moins trois types de batterie, et la première discrimination est mise en œuvre seulement si la tension de la cellule est inférieure ou égale à la tension de pleine charge la plus basse.

Dans des modes particuliers de mise en œuvre, les différents types de batterie considérés pour la cellule comportent les types LFP (Lithium-Fer-Phosphate), NCA (Nickel-Cobalt-Aluminium) et NMC (Nickel-Manganèse-Cobalt).

Dans des modes particuliers de mise en œuvre, la densité spectrale correspond à une densité spectrale d'une somme des composantes intrinsèques obtenues par la décomposition en modes empiriques.

Dans des modes particuliers de mise en œuvre, la densité spectrale correspond à une somme de densités spectrales calculées respectivement pour chacune des composantes intrinsèques obtenues par la décomposition en modes empiriques.

Dans des modes particuliers de mise en œuvre, chaque itération de ladite au moins une étape de discrimination comporte une analyse de fiabilité statistique de la phase CV en fonction des composantes intrinsèques du signal de dérivée du courant de floating.

Dans des modes particuliers de mise en œuvre, l'analyse de fiabilité comporte, pour chaque composante intrinsèque du signal de dérivée du courant de floating, un calcul d'une entropie de la composante intrinsèque.

Dans des modes particuliers de mise en œuvre, l'analyse de fiabilité comporte un calcul d'entropie d'une somme des composantes intrinsèques du signal de dérivée du courant de floating.

Selon un deuxième aspect, il est proposé un dispositif pour identifier le type d'une cellule de batterie lithium-ion parmi au moins deux types de batterie associés chacun respectivement à une tension de pleine charge différente. Le dispositif comporte un capteur adapté pour fournir des mesures de courant effectuées au niveau de la cellule pendant une phase CV d'un cycle de charge CC-CV de la cellule, et une unité de calcul configurée pour mettre en œuvre la méthode selon l'un quelconque des modes de mise en œuvre précédemment décrits.

## Présentation des figures

L'invention sera mieux comprise à la lecture de la description suivante, donnée à titre d'exemple nullement limitatif, et faite en se référant aux figures suivantes :

[Fig. 1] une représentation schématique des principales étapes d'un exemple de mise en œuvre de la méthode selon l'invention pour le tri d'une cellule de batterie lithium-ion selon son type,

[Fig. 2] un graphique représentant le courant circulant dans une cellule de batterie lithium-ion au cours de quatre cycles de charge CC-CV successifs,

[Fig. 3] un graphique représentant un signal de courant de floating circulant dans une cellule de batterie lithium-ion au cours d'une phase CV d'un cycle de charge CC-CV de la cellule,

[Fig. 4] un graphique représentant un signal de dérivée du courant de floating,

[Fig. 5] un graphique représentant une décomposition en modes empiriques du signal de dérivée du courant de floating représenté sur la figure 4,

[Fig. 6] une représentation schématique d'un mode particulier de mise en œuvre de l'invention avec au moins deux étapes de discrimination,

[Fig. 7] un graphique représentant les densités spectrales calculées respectivement pour deux cellules de type LFP, deux cellules de type NCA et deux cellules de type NMC lors d'une étape de discrimination utilisant une tension de charge correspondant à la tension de pleine charge d'une cellule de type LFP (3,65 V),

[Fig. 8] un graphique représentant les densités spectrales calculées respectivement pour deux cellules de type NCA et deux cellules de type NMC lors d'une étape de discrimination utilisant une tension de charge correspondant à la tension de pleine charge d'une cellule de type NCA (4,2 V),

[Fig. 9] une représentation schématique d'un dispositif selon l'invention permettant d'identifier le type d'une cellule de batterie lithium-ion.

Dans ces figures, des références identiques d'une figure à une autre désignent des éléments identiques ou analogues. Pour des raisons de clarté, les éléments représentés ne sont pas nécessairement à une même échelle, sauf mention contraire.

**Description détaillée de l'invention**

Un cycle de charge d'une cellule de batterie lithium-ion comporte classiquement deux phases : une première phase de charge à courant constant, ou phase CC (pour « Constant Current » en anglais) et une deuxième phase de charge à tension constante, ou phase CV (pour « Constant Voltage » en anglais). On parle alors d'un cycle de charge CC-CV. Dans la présente invention, on s'intéresse au courant qui circule dans la cellule pendant la phase CV. Ce courant est généralement appelé « courant de floating ».

Bien que classiquement la première phase de charge (phase CC) s'effectue à courant constant, des schémas de charge plus élaborés peuvent exister durant cette première phase, avec une évolution du courant par exemple pour maximiser la vitesse de charge tout en restant dans le domaine de charge compatible avec la cellule. La fin de la première phase de charge est alors marquée par l'atteinte d'un seuil de tension qui déclenche le basculement dans la seconde phase de charge à tension constante (phase CV). Par simplicité, on considèrera ces cas particuliers de première phase de charge comme également couverts par le vocable de charge CC-CV « courant constant - tension constante » utilisé dans cette demande.

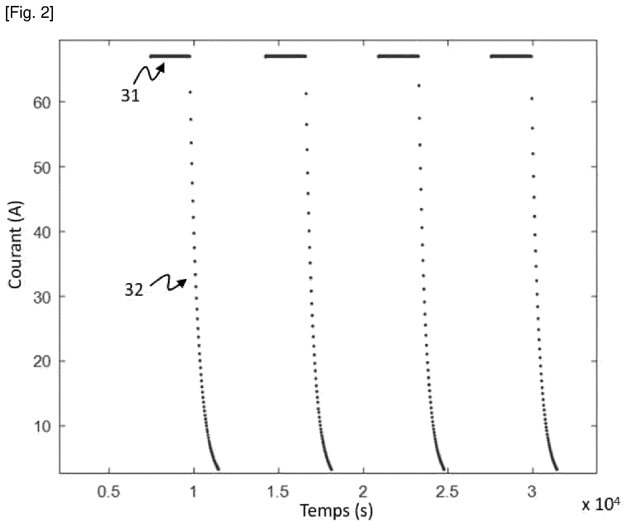

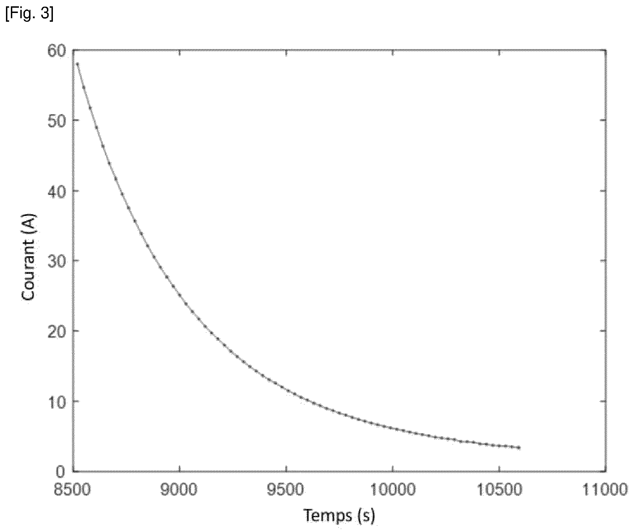

La figure 2 est un graphique représentant quatre cycles de charge CC-CV successifs d'une cellule de batterie lithium-ion. Le courant qui circule dans la cellule est représenté en ordonnée (en ampères) et le temps est représenté en abscisse (en secondes). Chaque cycle comporte une phase CC 31 et une phase CV 32. Tel qu'illustré sur le graphique de la figure 2, le courant qui circule dans la cellule pendant la phase CC 31 est sensiblement constant, et il présente une décroissance exponentielle pendant la phase CV 32. La figure 3 est un graphique représentant de façon plus détaillée le courant de floating d'une phase CV 32 de la cellule.

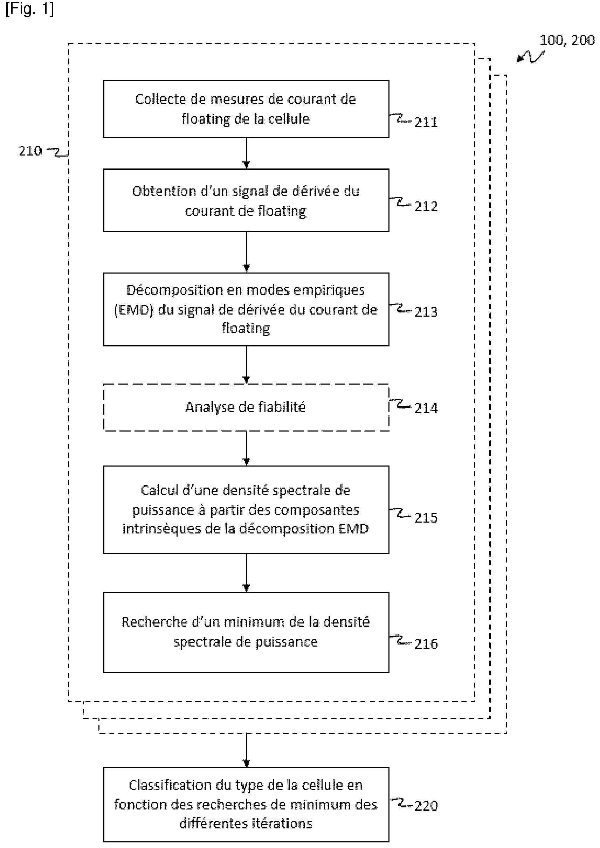

La figure 1 représente schématiquement les principales étapes d'un exemple de mise en œuvre de la méthode 100 selon l'invention pour le tri d'une cellule de batterie lithium-ion selon son type. La cellule est identifiée parmi au moins deux types de batterie associés chacun respectivement à une tension de pleine charge différente.

La méthode 100 comprend au moins une étape de discrimination 200. Le nombre maximal d'étapes de discrimination 200 à effectuer dépend du nombre de types de batterie auxquels la cellule est susceptible d'appartenir. Chaque étape de discrimination 200 comprend une ou plusieurs itérations 210. Chaque itération 210 comprend :

- une collecte 211 d'une pluralité de mesures de courant de floating acquise au niveau de la cellule pendant une phase CV effectuée avec une tension de charge correspondant à la tension de pleine charge la plus basse parmi les tensions de pleine charge associées aux différents types de batterie envisagés ; la pluralité de mesures forment un signal de « courant de floating » ;
- une dérivation 212 du signal de courant de floating pour obtenir un signal de dérivée du courant de floating ;
- une décomposition en modes empiriques 213 (ou décomposition EMD, pour « Empirical Mode Decomposition » en anglais) du signal de dérivée du courant de floating, afin d'en obtenir une représentation sous la forme d'une somme d'un signal résiduel et d'une ou plusieurs composantes intrinsèques ;
- un calcul 215 d'une densité spectrale à partir des composantes intrinsèques obtenues par la décomposition EMD ;
- une recherche 216 d'un minimum de la densité spectrale.

L'étape de discrimination 200 comprend en outre un classement 220 du type de la cellule en fonction d'un critère déterminé à partir du résultat de la recherche 216 de minimum obtenu pour ladite itération 210. Lorsque l'étape de discrimination 200 comprend plusieurs itérations 210, le critère peut être déterminé en fonction des résultats des recherches 216 de minimum obtenus pour les différentes itérations 210. Par exemple, le critère peut être satisfait dès qu'un minimum est trouvé pour une itération 210, ou dès qu'un minimum est trouvé pour un nombre prédéterminé d'itérations successives, ou si un minimum est trouvé pour un ratio prédéterminé d'itérations. Rien n'empêcherait toutefois d'envisager d'autres critères pour classer la cellule.

Lorsqu'il y a plusieurs itérations, il est préférable de remettre la cellule à sa tension initiale avec un cycle de décharge avant chaque nouvelle itération.

A titre d'exemple nullement limitatif, le régime de charge ou de décharge peut être de C/2. Le régime est souvent exprimé en unités de « C », où 1C signifie un courant de charge qui chargerait complètement la cellule en une heure (par exemple un régime de charge de C/2 pour une cellule de 2Ah correspond à un courant de charge de 1A). Le courant de charge à utiliser pendant la phase CV peut être estimé en fonction du format de la cellule (par exemple un courant de charge de 1A peut être utilisé pour les cellules de format 18650 et 21700 et pour les petites cellules cylindriques ou prismatiques. Un courant de charge plus élevé peut être utilisé pour les cellules plus grosses (par exemple les cellules de capacité supérieure ou égale à 5Ah).

A l'étape 211, les mesures de courant de floating pendant la phase CV sont effectuées par un capteur de courant connecté à la cellule. Les mesures sont par exemple effectuées avec une fréquence d'acquisition comprise entre une et soixante secondes, pendant une durée d'acquisition de cinq à trente minutes. Rien n'empêcherait toutefois de faire les mesures avec une fréquence d'acquisition différente, et/ou pendant une durée d'acquisition différente. Il est avantageux d'utiliser un nombre de mesures compris entre vingt et cent par phase CV (utiliser un plus grand nombre de mesures n'implique pas nécessairement une amélioration significative de la méthode, utiliser un nombre de mesures plus faible peut en revanche limiter les performances de la méthode). L'ensemble des mesures collectées pendant l'étape de collecte 110 forment un signal de « courant de floating ». Le graphique de la figure 3 représente un exemple de signal de courant de floating obtenu à l'étape de collecte 211.

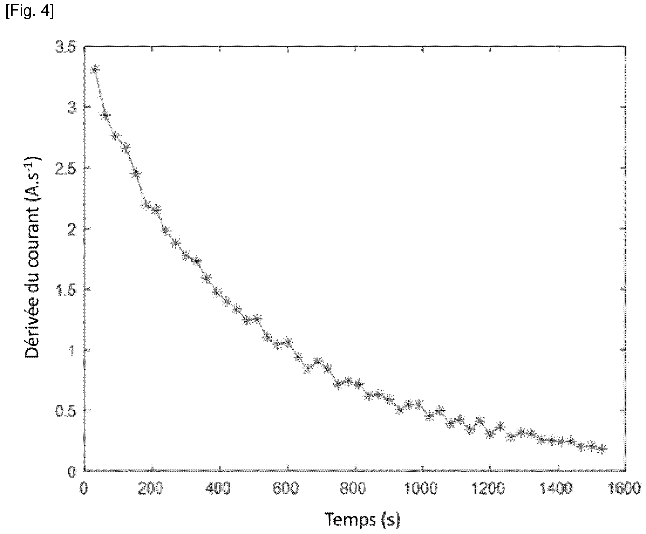

A l'étape de dérivation 212, le signal de courant de floating obtenu à l'étape 211 est dérivé pour obtenir un signal de dérivée de courant de floating. Le graphique de la figure 4 représente un exemple de signal de dérivée de courant de floating obtenu à l'étape de dérivation 212 (il s'agit de la dérivée du signal de courant de floating représenté sur le graphique de la figure 3).

A l'étape 213, le signal de dérivée de courant de floating est décomposé selon une décomposition en modes empiriques (décomposition EMD). Il convient de noter que le signal de courant de floating est généralement trop « lisse » et qu'il permet difficilement une décomposition en modes empiriques, c'est la raison pour laquelle on s'intéresse à sa dérivée, même si rien ne pouvait laisser présager au premier abord que ce signal de dérivée de courant de floating pouvait contenir des informations permettant de discriminer le type de chimie de la cellule en fonction de la tension de charge qui a été appliquée pendant la phase CV.

La décomposition en modes empiriques consiste à décomposer un signal sous la forme d'une somme de fonctions, de façon similaire à ce que fait la décomposition en série de Fourier ou la décomposition en ondelettes.

Une des particularités de la décomposition en modes empiriques est que la base de fonctions en lesquelles le signal est décomposé n'est pas connue a priori, mais elle est construite de façon adaptative en fonction des propriétés du signal.

La décomposition en modes empiriques correspond à la première partie de la transformée de Hilbert-Huang (HHT pour « Hilbert-Huang Transform » en anglais). La décomposition en modes empiriques consiste à décomposer un signal sous la forme d'une somme d'un signal résiduel et de fonctions de mode intrinsèque (IMF pour « Intrinsic Mode Function » en anglais). Dans la présente demande, ces fonctions de mode intrinsèque sont également appelées « composantes intrinsèques ».

Comme indiqué précédemment, les composantes intrinsèques ne sont pas définies analytiquement. Elles sont plutôt déterminées de façon adaptative en fonction des propriétés du signal.

Une composante intrinsèque (IMF) résultant d'une décomposition en modes empiriques (EMD) doit satisfaire aux exigences suivantes :

- le nombre d'extrema (c'est-à-dire la somme du nombre des maxima locaux et du nombre des minima locaux) et le nombre de passages par zéro de la composante intrinsèque doivent être égaux ou différer au maximum de un ;
- en tout point de la composante intrinsèque, la valeur moyenne de l'enveloppe définie par les maxima locaux et de l'enveloppe définie par les minima locaux est nulle.

Un signal $s(t)$ décomposé par EMD peut alors s'écrire sous la forme :

$$s(t) = r(t) + \sum_{i=1}^{N} c_i(t)$$

Dans cette expression, $r(t)$ correspond au signal résiduel, $N$ est le nombre de composantes intrinsèques de la décomposition EMD, et $c_i$ est la composante intrinsèque d'indice $i$. Chaque composante intrinsèque $c_i(t)$ successive contient des oscillations de fréquence inférieure à celle de la précédente. Le signal résiduel correspond à une tendance générale du signal $s(t)$.

La décomposition en modes empiriques comporte une succession de processus de tamisage (« sifting process » en anglais). Le premier processus de tamisage prend en entrée le signal $s(t)$ directement. Le processus de tamisage correspond à identifier tous les extrema locaux du signal d'entrée, et à relier les maxima locaux, respectivement les minima locaux, par une interpolation par splines cubiques, afin d'obtenir une enveloppe supérieure, respectivement une enveloppe inférieure. Une moyenne entre l'enveloppe supérieure et l'enveloppe inférieure peut alors être calculée et soustraite au signal d'entrée. Si le signal intermédiaire obtenu (soustraction du signal d'entrée avec la moyenne des enveloppes supérieure et inférieure) n'est pas une composante intrinsèque, le processus de tamisage est réitéré sur le signal intermédiaire (qui devient donc le signal d'entrée d'un nouveau processus de tamisage) jusqu'à obtenir une composante intrinsèque. Les processus de tamisage sont répétés jusqu'à obtenir la dernière composante intrinsèque, c'est-à-dire par exemple jusqu'à ce que le signal intermédiaire devienne monotone ou qu'il ne comporte plus qu'un seul extremum local. Le signal restant correspond alors au signal résiduel $r(t)$.

Un critère d'arrêt peut être défini pour le processus de tamisage. Par exemple le critère d'arrêt est satisfait si l'écart-type entre les résultats de deux processus de tamisage successifs est inférieur ou égale à un seuil d'arrêt prédéterminé. Le seuil d'arrêt peut typiquement être compris entre 0.2 et 0.3.

Le document « The empirical mode decomposition and the Hilbert spectrum for non-linear and non-stationary time series analysis », Norden E. Huang et al., Proc. R. Soc. Lond. A (1998) 454, p. 903-995, décrit de façon détaillée la décomposition en modes empiriques, notamment dans ses sections 4 et 5.

Des algorithmes de décomposition en modes empiriques sont disponibles dans des bibliothèques de programmation, par exemple en langage MATLAB ou Python.

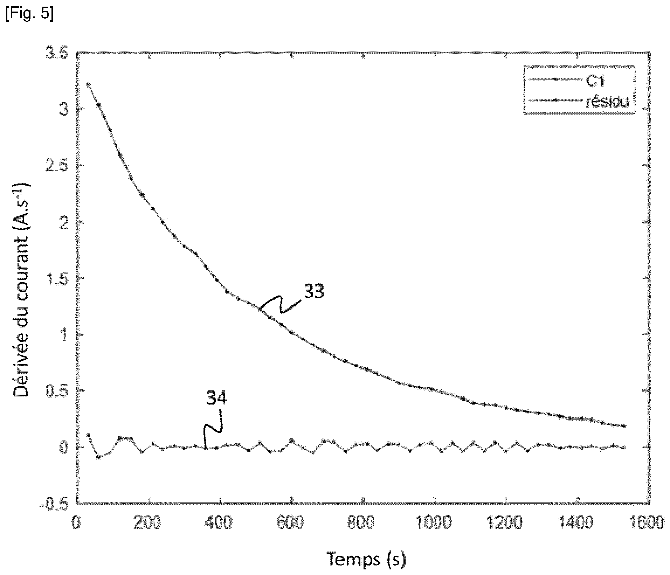

Le graphique de la figure 5 représente un exemple de décomposition en modes empiriques du signal de dérivée de courant de floating représenté sur la figure 4. Dans l'exemple considéré et illustré à la figure 5, la décomposition en modes empiriques a donné une seule composante intrinsèque 34 ($c_1$) et un signal résiduel 33. Il convient de noter que, dans d'autres exemples, un nombre plus important de composantes intrinsèques peut être obtenu. Le nombre de composantes intrinsèques reste toutefois généralement inférieur à cinq. Il est avantageux de paramétrer le seuil d'arrêt à un niveau relativement bas, de l'ordre de 0.2, pour extraire un maximum d'information du signal de dérivée de courant de floating. Utiliser un seuil d'arrêt plus faible impose des temps de calcul particulièrement importants.

Comme on le verra par la suite, il est également envisageable de filtrer certaines composantes intrinsèques qui seraient jugées non pertinentes, par exemple en fonction d'une entropie de la composante intrinsèque (une entropie trop faible peut signifier que la composante ne comporte pas suffisamment d'information pertinente, une entropie trop élevée peut correspondre à une valeur aberrante issue d'une erreur dans la décomposition EMD).

L'étape 215 correspond à un calcul une densité spectrale à partir des composantes intrinsèques obtenues par la décomposition EMD. Différentes méthodes peuvent être envisagées pour calculer cette densité spectrale.

Selon un premier exemple, la densité spectrale correspond à une densité spectrale d'une somme des composantes intrinsèques obtenues par la décomposition EMD.

Selon un deuxième exemple, la densité spectrale correspond à une somme de densités spectrales calculées respectivement pour chacune des composantes intrinsèques obtenues par la décomposition EMD.

La densité spectrale peut notamment être calculée par la méthode de Welch. Rien n'empêcherait toutefois d'utiliser d'autres méthodes d'estimation de densité spectrale, comme par exemple les méthodes de Bartlett ou de Blackman-Tukey. La densité spectrale peut également être calculée sous la forme du carré du module de la transformée de Fourier du signal considéré (composante intrinsèque ou somme de composantes intrinsèques) divisé par le temps d'intégration.

La densité spectrale peut optionnellement être calculée à partir d'une transformée de Hilbert du signal considéré. La transformation de Hilbert permet d'étendre un signal réel dans le domaine complexe. Le signal transformé présente alors des réponses d'amplitude nulle aux fréquences nulles. Cela permet d'éviter des artéfacts lors de l'exploitation des informations contenues dans le signal traité. La transformation de Hilbert permet ainsi d'optimiser le calcul de densité spectrale.

La densité spectrale peut éventuellement être normalisée, par exemple par rapport à une valeur maximale ou une valeur moyenne de la densité spectrale, ou bien par rapport à une valeur théorique prédéterminée.

Des algorithmes permettant ces calculs de transformation de Hilbert et d'estimation de densité spectrale sont disponibles dans des bibliothèques de programmation, par exemple en MATLAB ou en Python.

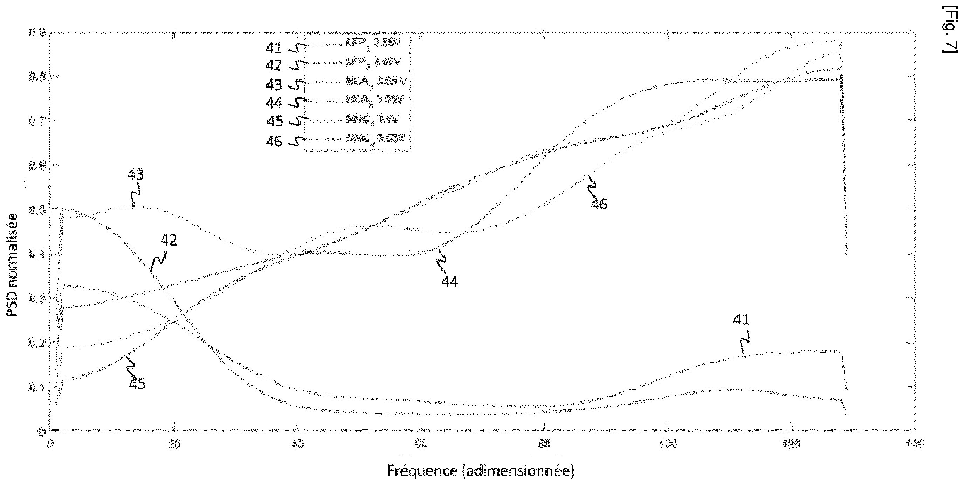

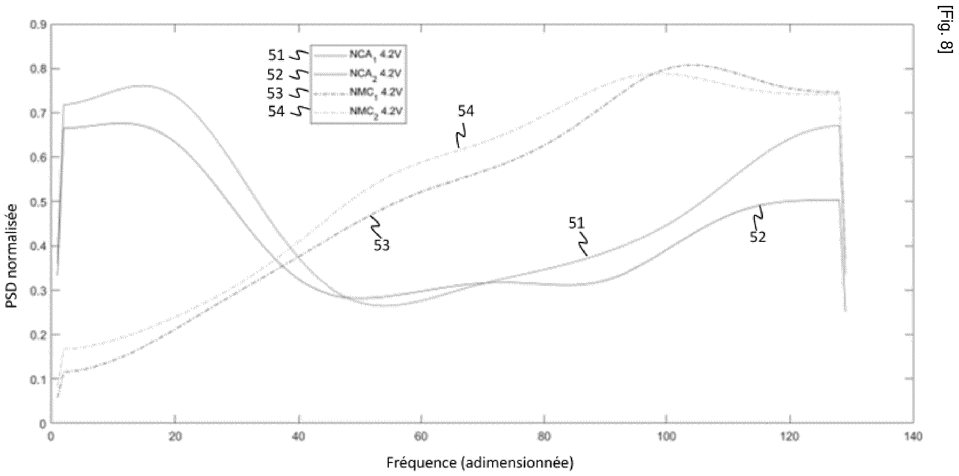

Les figures 7 et 8 montrent des exemples de densités spectrales calculées pour six cellules de batterie (deux cellules de type LFP, deux cellules de type NCA et deux cellules de type NMC). Chaque densité spectrale est calculée par la méthode de Welch à partir d'un signal correspondant à la somme des composantes intrinsèques obtenues par la décomposition EMD du signal de dérivée de courant de floating issu d'une phase CV de la cellule.

La figure 7 représente des densités spectrales calculées pour les six cellules à l'issue d'une phase CV avec une tension de charge de 3,65V. Cette valeur de tension correspond à la tension de pleine charge d'une cellule de batterie de type LFP. C'est la tension de pleine charge la plus basse parmi les trois types de batterie considérés ici (la tension de pleine charge d'une cellule de type NCA est de 4,2V ; la tension de pleine charge d'une cellule de type NMC est de 4,3V). Sur la figure 7, la courbe 41 représente la densité spectrale calculée pour la première cellule de type LFP ; la courbe 42 représente la densité spectrale calculée pour la deuxième cellule de type LFP ; la courbe 43 représente la densité spectrale calculée pour la première cellule de type NCA ; la courbe 44 représente la densité spectrale calculée pour la deuxième cellule de type NCA ; la courbe 45 représente la densité spectrale calculée pour la première cellule de type NMC ; la courbe 46 représente la densité spectrale calculée pour la deuxième cellule de type NMC.

La figure 8 représente les densités spectrales calculées pour les deux cellules de type NCA et les deux cellules de type NMC à l'issue d'une phase CV avec une tension de charge de 4,2V. Cette valeur de tension correspond à la tension de pleine charge d'une cellule de type NCA (elle est plus basse que la tension de pleine charge d'une cellule de type NMC). Sur la figure 8, la courbe 51 représente la densité spectrale calculée pour la première cellule de type NCA ; la courbe 52 représente la densité spectrale calculée pour la deuxième cellule de type NCA ; la courbe 53 représente la densité spectrale calculée pour la première cellule de type NMC ; la courbe 54 représente la densité spectrale calculé pour la deuxième cellule de type NMC.

Sur les figures 7 et 8, les densités spectrales sont normalisées, aussi bien en valeur (selon l'axe des ordonnées) qu'en fréquence (selon l'axe des abscisses). On peut observer des artéfacts au niveau de la valeur minimale et de la valeur maximale de fréquence. Comme indiqué précédemment, ces artéfacts peuvent être évités en utilisant une transformée de Hilbert. Il est également possible de les ignorer en réduisant la plage de fréquences pertinentes (on peut par exemple se placer dans un fenêtrage en retrait de trois à cinq points de fréquence à l'intérieur du spectre).

Tel qu'illustré sur les figures 7 et 8, il est possible de classer (étape 220 de la figure 1) le type d'une cellule en recherchant (étape 216 de la figure 1) un minimum de la densité spectrale calculée pour cette cellule.

Plus particulièrement, si la densité spectrale présente un minimum significatif, alors cela signifie que la cellule associée correspond au type de cellule dont la valeur de pleine charge a été utilisée pour la phase CV considérée. Dans le cas contraire, cela signifie que la cellule associée correspond à un autre type.

Sur la figure 7, on peut en effet observer un minium significatif des courbes 41 et 42 qui correspondent aux densités spectrales des cellules de type LFP (les courbes de la figure 7 ont été obtenue avec une tension de pleine de charge correspondant au type LFP). En revanche, les courbes 43, 44, 45 et 46 qui correspondent aux densités spectrales de cellules de type NCA ou NMC (pour lesquelles la tension de pleine charge est supérieure à celle d'une cellule de type LFP) ne présentent pas de minimum significatif.

De façon similaire, sur la figure 8, on peut observer un minium significatif des courbes 51 et 52 qui correspondent aux densités spectrales des cellules de type NCA (les courbes de la figure 8 ont été obtenue avec une tension de pleine de charge correspondant au type NCA). En revanche, les courbes 53 et 54, qui correspondent aux densités spectrales de cellules de type NMC (pour lesquelles la tension de pleine charge est supérieure à celle d'une cellule de type NCA) ne présentent pas de minimum significatif.

Un minimum significatif de la densité spectrale correspond par exemple à un minimum $f_{min}$ de la densité spectrale $PSD$ pour lequel il existe $f < f_{min}$ tel que

$$PSD(f_{min}) \leq \frac{PSD(f)}{2}$$ . Rien n'empêcherait toutefois d'utiliser une condition différente pour la recherche 216 de minimum de la densité spectrale. Le critère adéquat à utiliser peut par exemple être déterminé de façon empirique en laboratoire, éventuellement en fonction des types de batterie susceptibles d'être rencontrés.

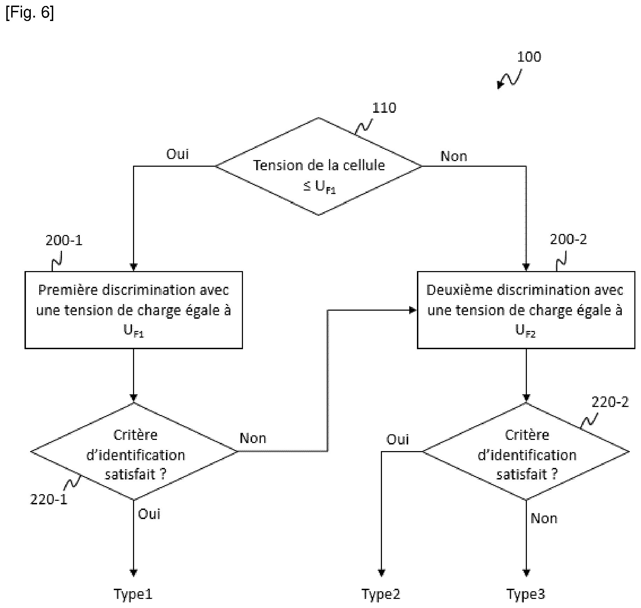

La figure 6 représente schématiquement les principales étapes d'un mode particulier de mise en œuvre de l'invention pour identifier le type d'une cellule de batterie parmi trois types différents. La méthode peut nécessiter jusqu'à deux étapes de discrimination pour identifier le type de la cellule.

Dans l'exemple considéré et illustré à la figure 6, le premier type (« Type1 ») correspond au type LFP, associé à une tension de pleine charge $U_{F1}$ égale à 3,65V. Le deuxième type (« Type2 ») correspond au type NCA, associé à une tension de pleine charge $U_{F2}$ égale à 4,2V. Le troisième type (« Type3 ») correspond au type NMC, associé à une tension de pleine charge $U_{F3}$ égale à 4,3V. On a donc $U_{F1} < U_{F2} < U_{F3}$.

Tel qu'illustré sur la figure 6, la méthode 100 comporte une première étape de discrimination 200-1 pour laquelle la phase CV est effectuée pour chaque itération avec la tension de charge $U_{F1}$ correspondant à la tension de pleine charge la plus basse parmi les tensions de pleine charge associées aux différents types de batterie envisagés. Il peut y avoir plusieurs itérations, par exemple entre trois et dix itérations. Rien n'empêcherait toutefois de ne faire qu'une seule itération.

A l'issue des itérations de la première discrimination 200-1, un critère d'identification permet de déterminer (à l'étape de classement 220-1 de la première étape de discrimination) si le type de la cellule correspond au premier type associé à la tension de pleine charge $U_{F1}$ (type LFP, lorsque le critère est satisfait) ou à l'un des autres types envisagés (type NCA ou NMC, lorsque le critère n'est pas satisfait).

Par exemple, le critère est satisfait si un minimum significatif est trouvé pour la densité spectrale de puissance pour au moins une itération, ou pour un nombre prédéterminé d'itérations (éventuellement successives) ou pour un ratio particulier d'itérations.

Si le critère n'est pas satisfait, la méthode 100 comporte une deuxième étape de discrimination 200-2 pour laquelle la phase CV est effectuée pour chaque itération avec une tension de charge $U_{F2}$ correspondant à la deuxième tension de pleine charge la plus basse parmi les tensions de pleine charge associées aux différents types de batterie envisagés. Là encore, la deuxième étape de discrimination 200-2 peut comporter une ou plusieurs itérations. Le nombre d'itérations utilisées à la première discrimination 200-1 peut être identique ou différent du nombre d'itérations utilisées à la deuxième étape de discrimination 200-2.

A l'issue des itérations de la deuxième étape de discrimination 200-2, un critère d'identification permet de déterminer (à l'étape de classement 220-2 de la première discrimination) si le type de la cellule correspond au deuxième type associé à la tension de pleine charge $U_{F2}$ (type NCA, lorsque le critère est satisfait) ou si elle correspond au troisième type (type NMC, lorsque le critère n'est pas satisfait). Le critère d'identification utilisé à la fin de la première étape de discrimination 200-1 peut être identique ou différent de celui utilisé à la fin de la deuxième étape de discrimination 200-2 (par exemple la condition utilisée pour la recherche 216 d'un minimum significatif de la densité spectrale et/ou le nombre d'itérations pour lesquelles la condition doit être satisfaite peut varier).

Tel qu'illustré sur la figure 6, la méthode 100 peut en outre comporter une étape préalable de comparaison 110 d'une tension de la cellule avec la tension de pleine charge $U_{F1}$. Si la tension de la cellule est supérieure à $U_{F1}$, alors la première discrimination 200-1 peut être omise et la deuxième discrimination 200-2 est suffisante pour déterminer le type de la cellule. En effet si la cellule est supérieure à $U_{F1}$, alors elle ne peut pas être de type LFP, et elle est nécessairement de type NCA ou NMC. La méthode 100 pourrait également comporter une comparaison de la tension de la cellule avec la tension de pleine charge $U_{F2}$ (cela n'est pas représenté sur la figure 6). Si la tension de la cellule est supérieure à $U_{F2}$, alors elle est nécessairement de type NMC car elle ne peut pas être de type LFP ni de type NCA.

Lorsque le nombre de types de batterie auxquels la cellule est susceptible d'appartenir est supérieur à trois, la méthode 100 décrite ci-avant peut être étendue en augmentant le nombre maximal d'étapes de discrimination qu'il sera éventuellement nécessaire d'effectuer pour identifier le type de la batterie. Lorsque le nombre de types de batterie auxquels la cellule est susceptible d'appartenir est égal à $N_T$, la méthode 100 peut nécessiter jusqu'à ($N_T$ - 1) étapes de discrimination pour identifier le type de la cellule.

Tel qu'illustré sur la figure 1, la méthode 100 selon l'invention peut également comporter une étape optionnelle d'analyse 214 de la fiabilité statistique de la phase CV associée à une itération, ou d'une composante intrinsèque du signal de dérivée du courant de floating pour la phase CV considérée. Une composante intrinsèque ou une phase CV jugée non fiable peut alors être écartée.

En particulier, la fiabilité statistique d'une composante intrinsèque ou d'une phase CV peut être estimée en fonction d'une entropie calculée pour chaque composante intrinsèque, ou en fonction d'une entropie calculée pour une somme des composantes intrinsèques du signal de température.

Différentes méthodes de calcul d'entropie peuvent être envisagés, comme par exemple un calcul d'entropie de Shannon, ou un calcul d'entropie de Kolmogorov. Par exemple, les phases CV pour lesquelles l'entropie de la somme des composantes intrinsèques est trop faible (inférieure à un seuil prédéterminé) sont filtrées. Un seuil d'entropie de Shannon compris entre 0.25 et 0.5 peut notamment être envisagé. Lorsque l'entropie est trop faible, cela peut signifier qu'il n'est pas possible de distinguer des fluctuations dynamiques du signal avec le bruit de fond.

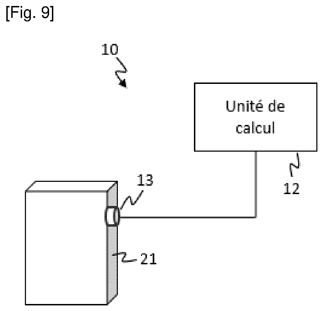

La figure 9 représente schématiquement un dispositif 10 pour identifier le type d'une cellule de batterie lithium-ion parmi au moins deux types de batterie associés chacun respectivement à une tension de pleine charge différente. Le dispositif 10 comporte un capteur 13 adapté pour fournir des mesures de courant effectuées au niveau de la cellule 21 pendant une phase CV d'un cycle de charge CC-CV de la cellule 21. Le dispositif 10 comporte également une unité 12 de calcul configurée pour mettre en œuvre la méthode 100 selon l'un quelconque des modes de mise en œuvre décrits ci-avant.

La communication entre le capteur 13 et l'unité 12 de calcul (pour la transmission des mesures de courant) peut être mise en œuvre par des moyens de communication filaires ou par des moyens de communication sans fil.

L'unité de calcul 12 et le capteur 13 peuvent faire partie d'un système de gestion de batterie (BMS pour « Battery Management System » en anglais). Selon un autre exemple, seul le capteur 13 fait partie d'un BMS et l'unité 12 de calcul appartient à un ordinateur auquel sont transmises les mesures de courant.

La description ci-avant illustre clairement que, par ses différentes caractéristiques et leurs avantages, la présente invention atteint les objectifs fixés. En particulier, l'analyse d'une densité spectrale calculée à partir des composantes intrinsèques de la décomposition EMD de la dérivée du courant de floating offre une solution innovante et relativement facile à mettre en œuvre pour trier des cellules de batteries lithium-ion selon leur type de chimie.

La solution a été présenté en prenant pour exemple les types LFP, NCA et NCM. Rien n'empêcherait toutefois d'appliquer la solution à d'autres types de cellules de batterie lithium-ion.

## Revendications

1. Méthode (100) pour identifier le type d'une cellule (21) de batterie lithium-ion parmi au moins deux types de batterie associés chacun respectivement à une tension de pleine charge différente, la méthode (100) comprenant au moins une étape de discrimination (200) comprenant une ou plusieurs itérations (210), chaque itération (210) comprenant :

   - une collecte (211) d'une pluralité de mesures de courant effectuées au niveau de la cellule (21) pendant une phase tension constante, ou phase CV, d'une charge « courant constant - tension constante », ou charge CC-CV, de la cellule (21), la phase CV étant effectuée avec une tension de charge correspondant à la tension de pleine charge la plus basse parmi les tensions de pleine charge associées auxdits au moins deux types de batterie, la pluralité de mesures formant un signal de « courant de floating »,

- une dérivation (212) du signal de courant de floating pour obtenir un signal de dérivée du courant de floating,
- une décomposition en modes empiriques (213) du signal de dérivée du courant de floating afin d'en obtenir une représentation sous la forme d'une somme d'un signal résiduel et d'une ou plusieurs composantes intrinsèques,
- un calcul (215) d'une densité spectrale à partir des composantes intrinsèques obtenues par la décomposition en modes empiriques (213),
- une recherche (216) d'un minimum de la densité spectrale,

l'étape de discrimination (200) comprenant :

- un classement (220) du type de la cellule (21) en fonction d'un critère déterminé à partir d'un résultat de la recherche (216) de minimum pour ladite au moins une itération (210).

2. Méthode (100) selon la revendication 1 dans laquelle ladite au moins une étape de discrimination (200) comprend plusieurs itérations (210), et le critère est déterminé en fonction des résultats des recherches (216) de minimum obtenus pour les différentes itérations (210).

3. Méthode (100) selon l'une quelconque des revendications 1 à 2 dans laquelle le critère est satisfait si un minimum $f_{min}$ de la densité spectrale $PSD$ pour lequel il existe $f < f_{min}$ tel que

$$PSD(f_{min}) \leq \frac{PSD(f)}{2}$$ est trouvé pour un nombre ou un ratio prédéterminé d'itérations.

4. Méthode (100) selon l'une quelconque des revendications 1 à 3 pour identifier le type de la cellule (21) parmi au moins trois types de batterie associés chacun respectivement à une tension de pleine charge différente ;

la méthode (100) comporte une première discrimination (200-1) pour laquelle la phase CV est effectuée pour chaque itération avec une tension de charge correspondant à la tension de pleine charge la plus basse parmi les tensions de pleine charge associées auxdits au moins trois types de batterie ;
si le critère est satisfait pour la première discrimination (200-1), le type de la cellule (21) correspond au type associé à la tension de pleine charge la plus basse ;
si le critère n'est pas satisfait pour la première discrimination (200-1), le type de la cellule (21) correspond à un type différent du type associé à la tension de pleine charge la plus basse, et la méthode (100) comporte une deuxième discrimination (200-2) pour laquelle la phase CV est effectuée pour chaque itération avec une tension de charge correspondant à la deuxième tension de pleine charge la plus basse parmi les tensions de pleine charge associées auxdits au moins trois types de batterie ;
si le critère est satisfait pour la deuxième discrimination (200-2), le type de la cellule (21) correspond au type associé à la deuxième tension de pleine charge la plus basse ;
si le critère n'est pas satisfait pour la deuxième discrimination (200-2), le type de la cellule correspond à un type différent du type associé à la deuxième tension de pleine charge la plus basse.

5. Méthode (100) selon la revendication 4 comportant une étape préalable de comparaison (110) d'une tension de la cellule (21) avec la tension de pleine charge la plus basse parmi les tensions de pleine charge associées auxdits au moins trois types de batterie, et la première discrimination (200-1) est mise en œuvre seulement si la tension de la cellule (21) est inférieure ou égale à la tension de pleine charge la plus basse.

6. Méthode (100) selon l'une quelconque des revendications 1 à 5 pour laquelle les différents types de batterie considérés pour la cellule (21) comportent les types LFP (Lithium-Fer-Phosphate), NCA (Nickel-Cobalt-Aluminium) et NMC (Nickel-Manganèse-Cobalt).

7. Méthode (100) selon l'une quelconque des revendications 1 à 6 dans laquelle la densité spectrale correspond à une densité spectrale d'une somme des composantes intrinsèques obtenues par la décomposition en modes empiriques (213).

8. Méthode (100) selon l'une quelconque des revendications 1 à 6 dans laquelle la densité spectrale correspond à une somme de densités spectrales calculées respectivement pour chacune des composantes intrinsèques obtenues par la décomposition en modes empiriques (213).

9. Méthode (100) selon l'une quelconque des revendications 1 à 8 dans laquelle chaque itération (210) de ladite au moins une étape de discrimination (200) comporte une analyse (214) de fiabilité statistique de la phase CV en fonction des composantes intrinsèques du signal de dérivée du courant de floating.

10. Méthode (100) selon la revendication 9 dans laquelle l'analyse (214) de fiabilité comporte, pour chaque composante intrinsèque du signal de dérivée du courant de floating, un calcul d'une entropie de la composante intrinsèque.

**11.** Méthode (100) selon l'une quelconque des revendication 9 à 10 dans laquelle l'analyse (214) de fiabilité comporte un calcul d'entropie d'une somme des composantes intrinsèques du signal de dérivée du courant de floating.

**12.** Dispositif (10) pour identifier le type d'une cellule (21) de batterie lithium-ion parmi au moins deux types de batterie associés chacun respectivement à une tension de pleine charge différente, le dispositif (10) comportant :

  - un capteur (13) adapté pour fournir des mesures de courant effectuées au niveau de la cellule (21) pendant une phase CV d'un cycle de charge CC-CV de la cellule (21),
  - une unité (12) de calcul configurée pour mettre en œuvre la méthode (100) selon l'une quelconque des revendications 1 à 11.

[Fig. 1]

100, 200

Collecte de mesures de courant de floating de la cellule — 211

210

Obtention d'un signal de dérivée du courant de floating — 212

Décomposition en modes empiriques (EMD) du signal de dérivée du courant de floating — 213

Analyse de fiabilité — 214

Calcul d'une densité spectrale de puissance à partir des composantes intrinsèques de la décomposition EMD — 215

Recherche d'un minimum de la densité spectrale de puissance — 216

Classification du type de la cellule en fonction des recherches de minimum des différentes itérations — 220

[Fig. 2]

[Fig. 3]

[Fig. 4]

[Fig. 5]

[Fig. 6]

[Fig. 7]

[Fig. 8]

[Fig. 9]

EP 4 723 296 A1

Europäisches
Patentamt

European
Patent Office

Office européen
des brevets

**RAPPORT DE RECHERCHE EUROPEENNE**

Numéro de la demande

EP 25 19 9865

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | NAVARATNE M A U S ET AL: "A simple battery chemistry identification and implementation technique for a self adaptable charger", INDUSTRIAL AND INFORMATION SYSTEMS (ICIIS), 2009 INTERNATIONAL CONFERENCE ON, IEEE, PISCATAWAY, NJ, USA, 28 décembre 2009 (2009-12-28), pages 163-168, XP031647968, ISBN: 978-1-4244-4836-4 * abrégé * * tableau 1 * * Section II: System Implementation * * Conclusion * | 1-12 | INV. H01M10/48 G01R31/378 H01M10/0525 G01R31/367 |
| A | US 2012/169271 A1 (DVORKIN ELIK [US] ET AL) 5 juillet 2012 (2012-07-05) * alinéas [0026], [0027], [0064] - [0068] * * revendications 1,7 * | 1-12 | |
| A | ZHAO YUNYI ET AL: "BatSort: Enhanced Battery Classification with Transfer Learning for Battery Sorting and Recycling", 2024 IEEE ANNUAL CONGRESS ON ARTIFICIAL INTELLIGENCE OF THINGS (AIOT), IEEE, 24 juillet 2024 (2024-07-24), pages 201-206, XP034703667, DOI: 10.1109/AIOT63253.2024.00047 * abrégé * * section II.B * * figure 1 * | 1-12 | |

DOMAINES TECHNIQUES RECHERCHES (IPC)

H01M
G01R

Le présent rapport a été établi pour toutes les revendications

| Lieu de la recherche | Date d'achèvement de la recherche | Examinateur |
|---|---|---|
| La Haye | 19 janvier 2026 | Grave, Christian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................
& : membre de la même famille, document correspondant

EPO FORM 1503 03.82 (P04C02)

20

## ANNEXE AU RAPPORT DE RECHERCHE EUROPEENNE
## RELATIF A LA DEMANDE DE BREVET EUROPEEN NO.

EP 25 19 9865

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-01-2026

| Document brevet cité au rapport de recherche | Date de publication | Membre(s) de la famille de brevet(s) | | Date de publication |
|---|---|---|---|---|
| US 2012169271 A1 | 05-07-2012 | CN | 103283082 A | 04-09-2013 |
| | | EP | 2659542 A1 | 06-11-2013 |
| | | US | 2012169271 A1 | 05-07-2012 |
| | | WO | 2012092241 A1 | 05-07-2012 |

EPO FORM P0460

## EP 4 723 296 A1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **NORDEN E. HUANG et al.** The empirical mode decomposition and the Hilbert spectrum for non-linear and non-stationary time series analysis. *Proc. R. Soc. Lond. A*, 1998, vol. 454, 903-995